# EUROPEAN PATENT APPLICATION

(11) **EP 4 813 867 A1**
(43) Date of publication of application: **30.09.2026**
(21) Application number: 24911933.0
(22) Date of filing: 16.10.2024
(51) Int. Cl.: B65D 85/86, H05K 13/02

(54) **COMPONENT ACCOMMODATING CONTAINER, AND COMPONENT ACCOMMODATING CONTAINER CONTAINING COMPONENTS**

(30) Priority: 27.12.2023 JP 2023220805
(71) Applicant: Murata Manufacturing Co., Ltd., Nagaokakyo-shi, Kyoto 617-8555 (JP)
(72) Inventor: NAKAGAWA, Kiyoyuki, Nagaokakyo-shi, Kyoto 617-8555 (JP)
(74) Representative: Stöckeler, Ferdinand
(86) International application number: PCT/JP2024/036825
(87) International publication number: WO 2025/142040

(57) **Abstract**

A component storage container includes: a case body including a storage space for storing a plurality of components, and a first component take-out opening through which components are taken into and out of the storage space; a cover member that is slidable along the first component take-out opening to open and close the first component take-out opening;
a second component take-out opening provided in the cover member; and
a guide groove provided in the case body to guide the cover member. When a direction in which the cover member extends is defined as a longitudinal direction, and a direction intersecting the longitudinal direction is defined as a lateral direction, the second component take-out opening is provided at a position excluding an end portion of the cover member in the lateral direction, and a maximum dimension of the second component take-out opening in the lateral direction is equal to or less than a maximum dimension of the first component take-out opening in the lateral direction.

## Description

### TECHNICAL FIELD

The present invention relates to a container for storing electronic components such as chip components.

### BACKGROUND ART

When mounting electronic components on a substrate, a mounting device is used to mount the electronic components at predetermined positions on the substrate. Such a mounting device requires individual supply of electronic components. For example, Patent Document 1 discloses a case that collectively stores electronic components in a loose state and causes the electronic components to fall by their own weight from a discharge port at the bottom to a feeder. In the case, the electronic components are stored through an opening (replenishment port) that opens upward, and the opening is opened and closed by an opening/closing lid. The electronic components are individually supplied to the mounting device by the feeder.

### Citation List

### Patent Document

Patent Document 1: Japanese Unexamined Patent Application, Publication No. 2009-295618

### DISCLOSURE OF THE INVENTION

### Problems to be Solved by the Invention

In this type of case, minute electronic components may enter a gap generated between the opening/closing member and the case, which may result in loss of electronic components or failure to smoothly discharge the electronic components.

It is an object of the present invention to provide a component storage container that is able to suppress loss of stored components and smoothly discharge components from a component take-out opening.

### Means for Solving the Problems

In order to solve the above problems, a component storage container according to an embodiment of the present disclosure includes: a case body including a storage space for storing a plurality of components, and a first component take-out opening through which components are taken into and out of the storage space; a cover member that is slidable along the first component take-out opening to open and close the first component take-out opening; a second component take-out opening provided in the cover member; and a guide groove provided in the case body to guide the cover member. When a direction in which the cover member extends is defined as a longitudinal direction, and a direction intersecting the longitudinal direction is defined as a lateral direction, the second component take-out opening is provided at a position excluding an end portion of the cover member in the lateral direction, and a maximum dimension of the second component take-out opening in the lateral direction is equal to or less than a maximum dimension of the first component take-out opening in the lateral direction.

This configuration makes it possible to reduce loss of stored components and smoothly discharge components from the component take-out opening.

### Effects of the Invention

The embodiments of the present invention make it possible to reduce loss of stored components and smoothly discharge components from the component take-out opening.

### BRIEF DESCRIPTION OF THE DRAWINGS

FIG. 1 is a perspective view schematically showing a component storage container according to Embodiment 1 of the present invention.
FIG. 2 is a front view of the component storage container according to Embodiment 1.
FIG. 3 is a bottom view of the component storage container according to Embodiment 1.
FIG. 4A is a development view of one side of the case body in Embodiment 1.
FIG. 4B is a development view of the other side of the case body in Embodiment 1.
FIG. 5 is a schematic cross-sectional view of the component storage container according to Embodiment 1 (Embodiment 4) in which electronic components are being stored.
FIG. 6 is a plan view showing an example of a cover member used in Embodiment 1.
FIG. 7 is a cross-sectional view showing a state in which an operation pin is inserted into an operation hole of a slide member in Embodiment 1.
FIG. 8A is a perspective view showing a state in which the first component take-out opening is closed by the cover member in the component storage container according to Embodiment 1.
FIG. 8B is a perspective view showing a state in which a portion of the second component take-out opening of the cover member and the first component take-out opening are in communication in Embodiment 1.
FIG. 8C is a perspective view showing a state in which the second component take-out opening of the cover member and the first component take-out opening are in communication in Embodiment 1.
FIG. 9 is a plan view showing an example of a cover member used in Embodiment 2.
FIG. 10A is a perspective view showing a state in which the first component take-out opening is closed by the cover member in Embodiment 2.
FIG. 10B is a perspective view showing a state in which a portion of the second component take-out opening of the cover member and the first component take-out opening are in communication in Embodiment 2.
FIG. 10C is a perspective view showing a state in which the second component take-out opening of the cover member and the first component take-out opening are in communication in Embodiment 2.
FIG. 10D is a perspective view showing a state in which a portion of the second component take-out opening of the cover member and the first component take-out opening are in communication in Embodiment 2.
FIG. 10E is a perspective view showing a state in which the first component take-out opening is closed by the cover member in Embodiment 2.
FIG. 11 is a plan view showing an example of a cover member used in Embodiment 3.
FIG. 12A is a perspective view showing a state in which the first component take-out opening is closed by the cover member in Embodiment 3.
FIG. 12B is a perspective view showing a state in which a portion of the second component take-out opening of the cover member and the first component take-out opening are in communication in Embodiment 3.
FIG. 12C is a perspective view showing a state in which the second component take-out opening of the cover member and the first component take-out opening are in communication in Embodiment 3.
FIG. 13 is a perspective view showing a portion of a conventional component storage container.

### PREFERRED MODE FOR CARRYING OUT THE INVENTION

Hereinafter, a component storage container according to an embodiment of the present disclosure will be described in detail with reference to illustrated embodiments. The drawings include some schematic representations and may not reflect actual dimensions and ratios.

### <Embodiment 1>

### Embodiment 1 will be described below.

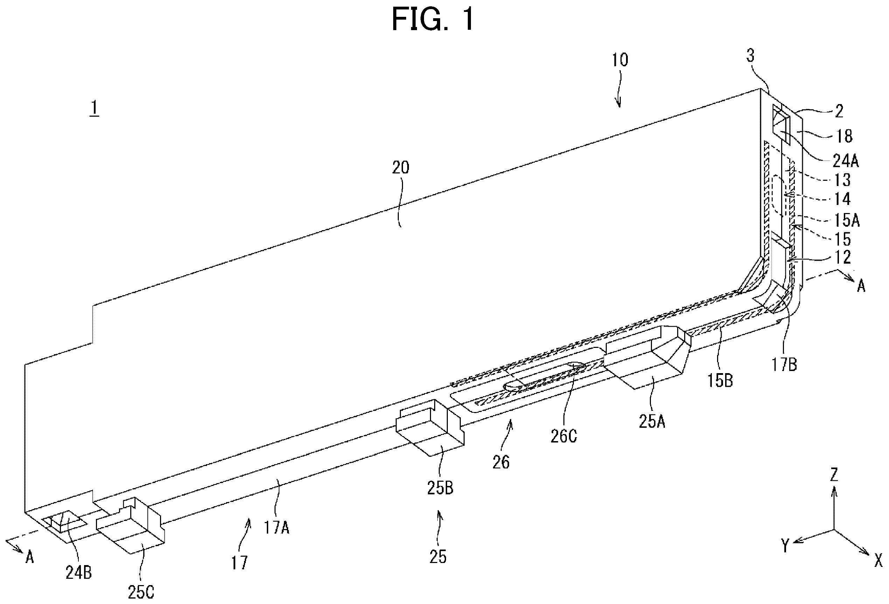

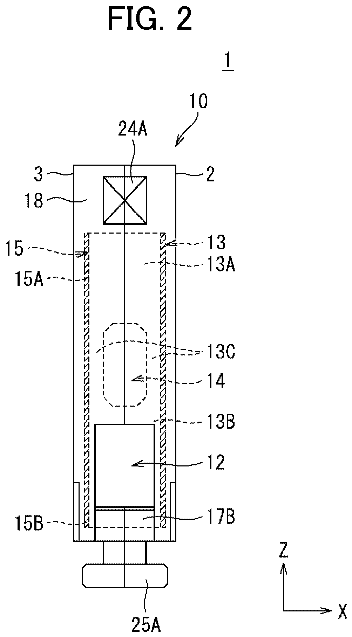

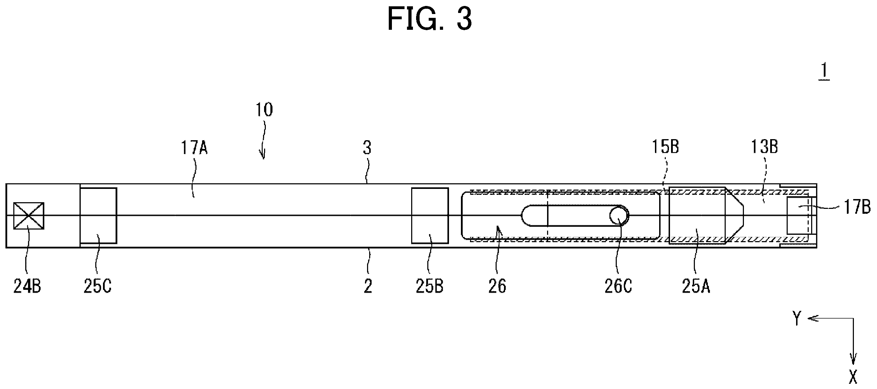

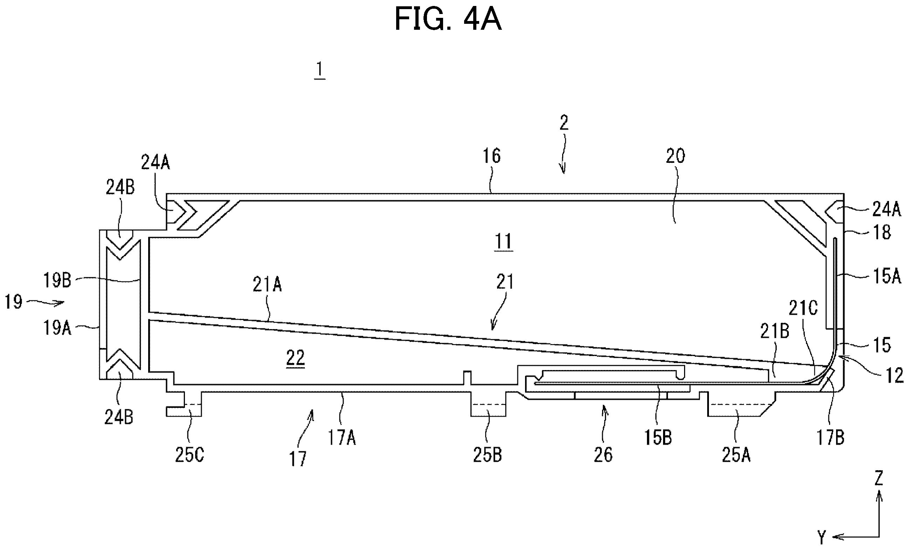

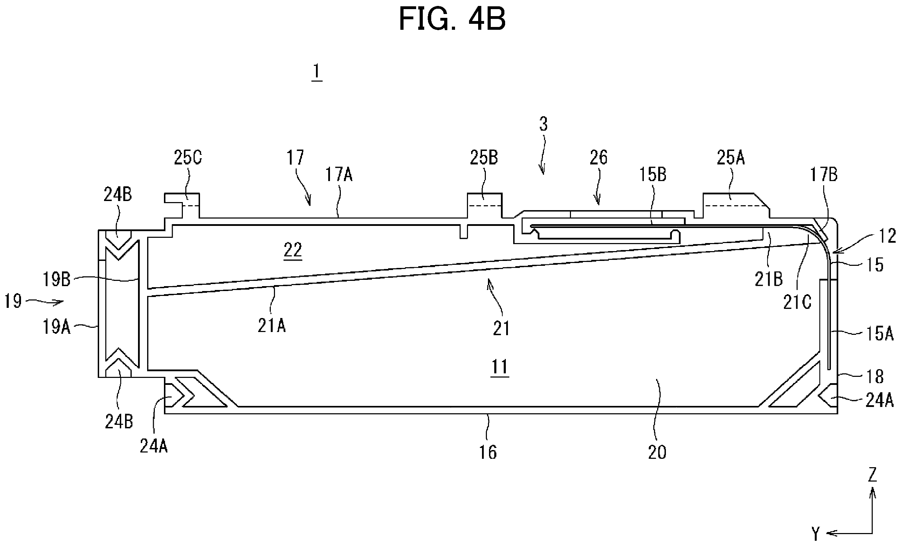

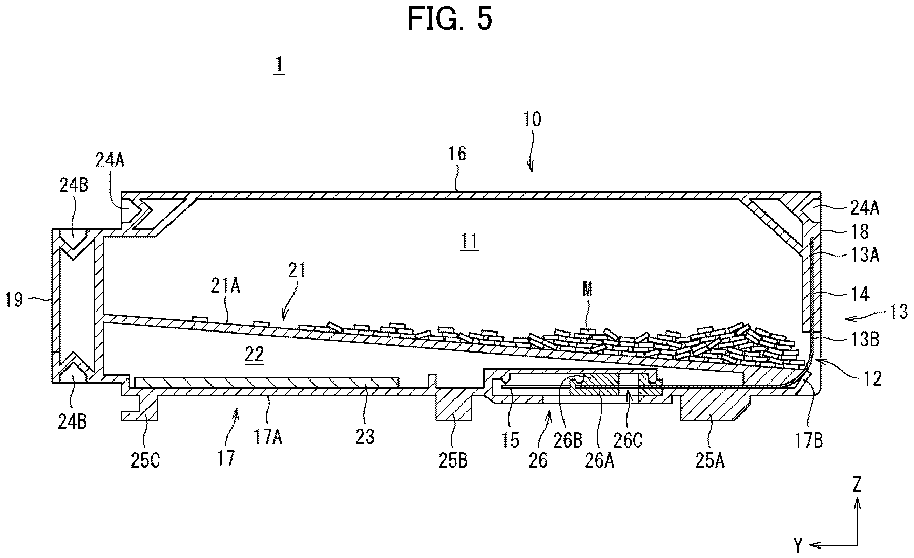

FIG. 1 is a perspective view schematically showing Embodiment 1 of a component storage container. FIG. 2 is a front view of Embodiment 1 of the component storage container. FIG. 3 is a bottom view of Embodiment 1 of the component storage container. FIGS. 4A and 4B are development views of a case body in Embodiment 1. FIG. 5 is a schematic cross-sectional view of the component storage container of Embodiment 1 (Embodiment 4) in which electronic components are being stored. In FIGS. 1 to 3, a guide groove 15 is hatched for convenience. In FIGS. 4A and 4B, a cover member 13 is omitted for convenience. FIGS. 4A and 4B are views showing a case body 10 in a developed state in a cross section A-A of FIG. 1.

In the drawings, arrow X indicates a direction in which a pair of side wall portions 20, which will be described later, are opposed to each other (hereinafter referred to as a width direction X). Arrow Y indicates a direction in which a front wall portion 18, which will be described later, and a rear wall portion 19, which will be described later, are opposed to each other (hereinafter referred to as a length direction Y). The length direction Y is perpendicular to the width direction X. Arrow Z indicates a direction in which a top plate portion 16 and a bottom plate portion 17, which will be described later, are opposed to each other (hereinafter referred to as a height direction Z). The height direction Z is perpendicular to the width direction X and the length direction Y. A direction from the bottom plate portion 17 toward the top plate portion 16 is defined as an upward direction, a direction opposite to the upward direction is defined as a downward direction, a direction from a first member 2, which will be described later, toward a second member 3, which will be described later, is defined as a leftward direction, a direction opposite to the leftward direction is defined as a rightward direction, a direction from the rear wall portion 19 toward the front wall portion 18 is defined as a forward direction, and a direction opposite to the forward direction is defined as a backward direction. An upper side of an element refers to a side of the element in the upward direction. A lower side of an element refers to a side of the element in the downward direction. A front side of an element refers to a side of the element in the forward direction. A rear side of an element refers to a side of the element in the backward direction.

As shown in FIG. 1, the component storage container 1 includes a case body 10, a cover member 13 that opens and closes a first component take-out opening 12 by sliding along the first component take-out opening 12, a second component take-out opening 14 provided in the cover member 13, and the guide groove 15 provided in the case body 10 for guiding the cover member 13.

### (Case Body)

As shown in FIGS. 1 to 3, the case body 10 includes a first member 2 and a second member 3 that are combined and joined to each other. As shown in FIGS. 4A and 4B, the case body 10 includes a storage space 11 provided therein by the first member 2 and the second member 3 in order to store a plurality of electronic components M (see FIG. 5). The case body 10 includes the storage space 11 for storing a plurality of components, and the first component take-out opening 12 through which the electronic components M are discharged from the storage space 11.

As shown in FIGS. 4A and 4B, the case body 10 includes the top plate portion 16 and the bottom plate portion 17 that extend in the length direction Y, the front wall portion 18 and the rear wall portion 19 that extend in the height direction Z, the pair of side wall portions 20 that extend in the length direction Y, and a sloped portion 21 that is provided inside the storage space 11 and extends toward the first component take-out opening 12.

The rear wall portion 19 includes an outer rear wall portion 19A that provides an outer surface, and an inner rear wall portion 19B that is located forward from the outer rear wall portion 19A. The bottom plate portion 17 includes the bottom portion 17A that is provided opposed to the top plate portion 16, and the bottom plate end portion 17B that is provided at an end portion in the length direction Y of the bottom plate portion 17 adjacent to the front wall portion 18.

The case body 10 includes a pair of upper gripping portions 24A and a pair of rear gripping portions 24B. The upper gripping portions 24A refer to a pair of recesses provided at front and rear ends on the upper side of the case body 10. The rear gripping portions 24B refer to a pair of recesses provided at upper and lower ends on the rear side of the case body 10.

As shown in FIG. 5, the component storage container 1 stores a plurality of electronic components M as components in a loose state in the storage space 11. The component storage container 1 that stores the plurality of electronic components M is set in a feeder (not shown). When the first component take-out opening 12 and the second component take-out opening 14 overlap, the electronic components M are discharged from inside the component storage container 1 by vibration of the feeder and supplied to a mounting device (not shown) or the like. The electronic components M are, for example, minute rectangular parallelepipeds each having a length in the longitudinal direction of 1.0 mm or less. The electronic components M are not particularly limited, and examples thereof include capacitors or inductors.

### (First Component take-out opening)

As shown in FIG. 1 and the like, the first component take-out opening 12 is an opening portion provided below the front wall portion 18 of the case body 10, and the first component take-out opening 12 is opened and closed by the cover member 13. The first component take-out opening 12 allows the electronic component M to be taken in and out with respect to the storage space 11. The first component take-out opening 12 is surrounded by the guide groove 15, a lower end portion of the front wall portion 18, and the bottom plate end portion 17B.

In the present embodiment, the first component take-out opening 12 has a substantially rectangular shape. The first component take-out opening 12 may have, for example, a circular shape or an elliptical shape.

The guide groove 15 is curved so as to extend toward the tip of the sloped portion 21 in the vicinity of the first component take-out opening 12. The first component take-out opening 12 has a shape that is curved along the shape of the curved guide groove 15.

The tip of the bottom plate end portion 17B, which defines the lower end portion of the first component take-out opening 12, is provided below the end portion of the sloped surface 21A in the length direction Y, such that the electronic components M stored in the storage space 11 is able to be smoothly taken in and out.

### (Sloped Portion 21)

The sloped portion 21 is a plate member that extends between the pair of opposing side wall portions 20 and extends from the inner rear wall portion 19B toward the first component take-out opening 12. Inside the case body 10, the upper side in the height direction Z of the sloped portion 21 refers to the storage space 11, and the lower side in the height direction Z refers to the lower space 22.

The sloped portion 21 includes a sloped surface 21A toward the storage space 11, a protruding portion 21B provided at an end portion of the sloped portion 21 adjacent to the first component take-out opening 12 in the length direction Y and provided below the sloped surface 21A, and a front end surface 21C provided on a lower surface of the protruding portion 21B. The sloped surface 21A is provided such that a tip of the sloped surface 21A adjacent to the front wall portion 18 is located above a tip of the bottom plate end portion 17B in the height direction Z.
This configuration reduces or prevents the electronic components M from being caught between the protruding portion 21B and the bottom plate end portion 17B when the electronic components M are removed from the case body.

The sloped portion 21 includes the sloped surface 21A having a downward slope toward the first component take-out opening 12. In the present embodiment, an angle (slope angle θ1) between the sloped surface 21A and the bottom portion 17A is approximately 5°. The slope angle θ1 of the sloped surface 21A is preferably 3° or more and 10° or less. The slope angle θ1 of the sloped surface 21A is appropriately designed according to vibration conditions of the feeder.

### (RFID Tag 23)

A band-shaped RFID tag 23 that is long in the forward-backward direction is provided on the rear side of the lower space 22. The RFID tag 23 is, for example, adherable and is attached to the upper side of the bottom plate portion 17. The RFID tag 23 includes a transmission-reception unit, memory, an antenna, and the like, and has a known configuration. The feeder includes a reader-writer that reads and writes information of the RFID tag 23.

### (Upper Gripping Portion 24A and Rear Gripping Portion 24B)

Each of the upper gripping portions 24A and each of the rear gripping portions 24B are gripped by, for example, a robot hand (not shown). The component storage container 1 is transported to a position of a feeder by the robot hand.

### (Multiple Claw Portions 25)

The case body 10 includes a plurality of claw portions 25 on the outside of the bottom plate portion 17 in order to removably set the component storage container 1 to a feeder. In the present embodiment, a first claw portion 25A, a second claw portion 25B, and a third claw portion 25C are provided on the bottom plate portion 17 at intervals in the forward-backward direction. Each of the first claw portion 25A, the second claw portion 25B, and the third claw portion 25C is integrally molded with the case body 10. Each of the first claw portion 25A and the second claw portion 25B has an inverted T-shape in a cross section along a plane (XZ plane) formed by a straight line extending in the width direction X and a straight line extending in the height direction Z. The third claw portion 25C is an L-shaped plate piece portion in a cross section along a plane (YZ plane) formed by a straight line extending in the length direction Y and a straight line extending in the height direction Z.

### (Guide Groove 15)

The guide groove 15 is a groove for guiding the slide movement of the cover member 13, and is provided in the front wall portion 18. A direction in which the cover member 13 alone extends is defined as a longitudinal direction, and a direction intersecting the longitudinal direction is defined as a lateral direction. When the cover member 13 is set in the guide groove 15, the cover member 13 extends along the guide groove 15 in the height direction Z and the length direction Y.

The width of the guide groove 15 may be 0.11 mm or more and 0.6 mm or less. The width of the guide groove 15 refers to a dimension in the thickness direction of the cover member 13. The thickness direction of the cover member 13 refers to a direction orthogonal to the longitudinal direction and the lateral direction. It is preferable that the width of the guide groove 15 is greater than the thickness of the cover member 13, and that the difference between the width of the guide groove 15 and the thickness of the cover member 13 is smaller than the minimum dimension of each of the electronic components M accommodated in the storage space 11.

The guide groove 15 is provided in the length direction Y and the height direction Z of the case body 10. The guide groove 15 includes an upper guide portion 15A located above the end portion in the length direction Y of the sloped portion 21, and a lower guide portion 15B located below the end portion in the length direction Y of the sloped portion 21.

The lower guide portion 15B is provided in each of the pair of side wall portions 20, and is provided above the bottom plate portion 17. The upper guide portion 15A is provided on the inner surface in the width direction X of the first component take-out opening 12 and inside the front wall portion 18. The cover member 13 is slidable along the lower guide portion 15B and the upper guide portion 15A. In the lower guide portion 15B, the cover member 13 slides generally in the forward-backward direction, and in the upper guide portion 15A, the cover member 13 slides in the upward-downward direction.

Each of the lower guide portion 15B and the upper guide portion 15A provides a passage for sliding the cover member 13 while maintaining the lateral direction of the cover member 13 in a state along the width direction X.

A portion of the lower guide portion 15B is configured as a gap provided between the front end surface 21C and the bottom plate portion 17. The above-described portion of the lower guide portion 15B has a curved shape along the shape of the front end surface 21C. The upper guide portion 15A is curved toward the sloped portion 21 around the bottom plate end portion 17B, and is smoothly connected to the lower guide portion 15B.

### (Cover Member 13)

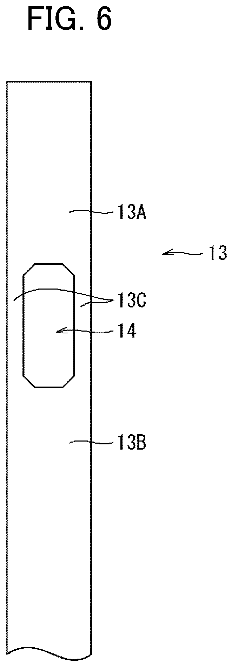

FIG. 6 is a plan view showing an example of the cover member 13 used in Embodiment 1.

The cover member 13 slides along the first component take-out opening 12 to open and close the first component take-out opening 12.

Both end portions of the cover member 13 in the lateral direction are inserted into the pair of guide grooves 15, respectively, such that the cover member 13 can slide along the guide grooves 15. The cover member 13 is provided such that the lateral direction thereof corresponds to the width direction X of the case body 10.

The cover member 13 includes the second component take-out opening 14, an upper cover member 13A, a lower cover member 13B, and a pair of coupling portions 13C. The upper cover member 13A and the lower cover member 13B are portions that sandwich the second component take-out opening 14 and in which the second component take-out opening 14 is not provided. The upper cover member 13A is provided on one side in the length direction. The dimension of the upper cover member 13A in the longitudinal direction is equal to or less than the dimension of the lower cover member 13B in the longitudinal direction. The lower cover member 13B is provided on the other side in the length direction. The dimension of the lower cover member 13B in the longitudinal direction is equal to or more than the dimension of the upper cover member 13A in the longitudinal direction. The upper cover member 13A and the lower cover member 13B are coupled by the pair of coupling portions 13C at both end portions of the second component take-out opening 14 in the lateral direction. The dimensions of the upper cover member 13A and the lower cover member 13B in the lateral direction are such that both end portions of each of the upper cover member 13A and the lower cover member 13B in the lateral direction can be inserted into the pair of guide grooves 15.

The cover member 13 has an elongated band shape. The cover member 13 is made of, for example, a resin film. As the material of the cover member 13, a plastic material having a certain degree of rigidity and bendable may be used. Examples of such a material for the cover member 13 include polyethylene terephthalate (PET) resin. The surface resistance value of the cover member 13 is preferably in a range of 10⁹ Ω·sq or more and 10¹³ Ω·sq or less.

In a case of using a material having a surface resistance value in a range of 10⁹ Ω·sq or more and 10¹³ Ω·sq or less as the cover member 13 of the present embodiment, the surface resistance value of the pair of coupling portions 13C is also in the range of 10⁹ Ω·sq or more and 10¹³ Ω·sq or less.

The electronic components M in the storage space 11 may be charged with static electricity, which may lead to malfunction of the electronic components M. By using a material having a surface resistance value of 10⁹ Ω·sq or more and 10¹³ Ω·sq or less for the pair of coupling portions 13C, even in a case in which the electronic components M contact the pair of coupling portions 13C, it is possible to discharge the static electricity charged in the electronic components M, thereby eliminating malfunction of the electronic components M due to charging.

The thickness of the cover member 13 is, for example, 0.1 mm or more and 0.5 mm or less. The outer dimension of the cover member 13 in the lateral direction is larger than the outer dimension of the first component take-out opening 12 in the lateral direction. Such a configuration makes it possible to insert the cover member 13 into the guide grooves 15, and to close the first component take-out opening 12 with the cover member 13.

As shown in FIG. 5, the lower cover member 13B passes through a gap between the front end surface 21C and the bottom plate portion 17 in the lower guide portion 15B. With such a configuration, the cover member 13 provided in the lower guide portion 15B slides in the forward-backward direction directly above the bottom plate portion 17. The cover member 13 curves in a direction protruding forward along the front end surface 21C. In the lower guide portion 15B, the cover member 13 can slide along the gap between the bottom portion 17A, the bottom plate end portion 17B, and the front end surface 21C. With such a configuration, the cover member 13 bends upward at an angle of approximately 90° from the forward-backward direction, and changes to a posture extending in the upward-downward direction.

The cover member 13 provided along the guide grooves 15 is curved along the shape of the guide grooves 15. In a case in which the cover member 13 slides from the upper guide portion 15A toward the lower guide portion 15B, the sliding direction is changed from the height direction Z to the length direction Y.

### (Relationship Between Guide Groove 15 and Cover Member 13)

The width of the guide groove 15 is greater than the thickness of the cover member 13. In the present embodiment, the difference between the width of the guide groove 15 and the thickness of the cover member 13 is smaller than the minimum dimension of each of the electronic components M stored in the storage space 11.

More preferably, the difference between the width of the guide groove 15 and the thickness of the cover member 13 is greater than 0 mm and 0.09 mm or less. When the difference between the width of the guide groove 15 and the thickness of the cover member 13 is greater than 0 mm, the cover member 13 slides smoothly, and when the difference is 0.09 mm or less, it is possible to further reduce the occurrence of a problem in that the electronic component M having a minimum dimension of 0.1 mm or more is caught between the guide groove 15 and the cover member 13. When the difference between the width of the guide groove 15 and the thickness of the cover member 13 falls within a range of greater than 0 mm and 0.09 mm or less, it is possible to reduce the likelihood of the electronic component M being caught between the guide groove 15 and the cover member 13, thereby smoothly taking out the electronic components M from the storage space 11.

More preferably, the difference between the width of the guide groove 15 and the thickness of the cover member 13 is greater than 0 mm and 0.04 mm or less. When the difference between the width of the guide groove 15 and the thickness of the cover member 13 is greater than 0 mm, the cover member 13 slides smoothly, and when the difference is 0.04 mm or less, it is possible to further reduce the occurrence of a problem in that the electronic component M having a minimum dimension of 0.05 mm or more is caught between the guide groove 15 and the cover member 13.

### (Second Component take-out opening 14)

The second component take-out opening 14 is a through hole created by cutting out the cover member 13.

In the present embodiment, the second component take-out opening 14 has a rectangular shape with rounded corners. The shape is not limited to this, and the second component take-out opening 14 may have various shapes such as a rectangular shape, a polygonal shape, an elliptical shape, or a circular shape.

When the first component take-out opening 12 and the second component take-out opening 14 overlap, the storage space 11 and the external space communicate with each other, and it is possible to take out the electronic components M in the storage space 11.

The second component take-out opening 14 is provided at a position excluding end portions in the lateral direction of the cover member 13. In the present embodiment, when the first component take-out opening 12 and the second component take-out opening 14 overlap, the second component take-out opening 14 is provided near the middle in the lateral direction of the first component take-out opening 12.

In the present embodiment, when the first component take-out opening 12 and the second component take-out opening 14 overlap, an imaginary line passing through the middle in the lateral direction of the second component take-out opening 14 and an imaginary line passing through the middle in the lateral direction of the cover member 13 substantially coincide with each other.

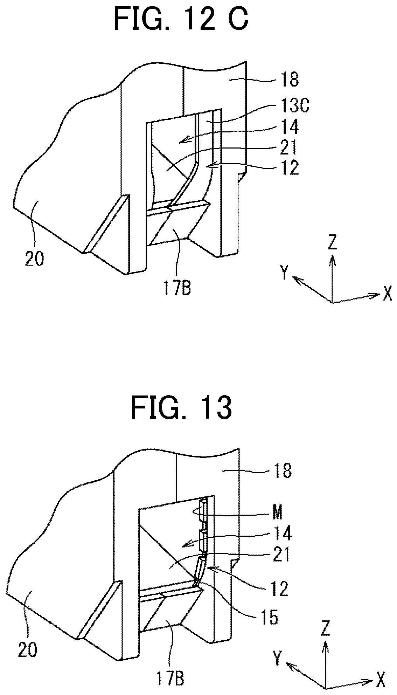

FIG. 13 is a perspective view showing a portion of a conventional component storage container. As shown in FIG. 13, in the conventional container, the cover member 13 is not inserted inside the guide groove 15, or the dimension in the lateral direction of the cover member inside the guide groove 15 is smaller than the depth of the guide groove 15, and thus the electronic component M may be caught in the guide groove 15 when being taken out.

In contrast, in the present embodiment, the second component take-out opening 14 is provided at a position excluding the end portions in the lateral direction of the cover member 13, and the maximum dimension in the lateral direction of the second component take-out opening 14 is equal to or less than the maximum dimension in the lateral direction of the first component take-out opening 12.

Therefore, the dimension in the lateral direction of the portion of the cover member 13 inserted into the guide groove 15 substantially coincides with the depth of the guide groove 15. As a result, when the electronic components M are discharged from the first component take-out opening 12, the cover member 13 inserted into the guide groove 15 makes it unlikely for the electronic components M to enter the guide groove 15, thereby reducing the likelihood of the electronic components M being caught in the guide groove 15.

When at least a portion of the first component take-out opening 12 and at least a portion of the second component take-out opening 14 overlap and the inside and outside of the case body 10 communicate with each other, it can be observed that a portion of the cover member 13 (the pair of coupling portions 13C) extends into the first component take-out opening 12 in the lateral direction. That is, the maximum dimension in the lateral direction of the second component take-out opening 14 is smaller than the maximum dimension in the lateral direction of the first component take-out opening 12. This configuration more reliably makes it unlikely for the electronic components M to enter the guide groove 15, thereby reducing the electronic components M from being caught in the guide groove 15.

The maximum dimension in the lateral direction of the second component take-out opening 14 may be the same as the maximum dimension in the lateral direction of the first component take-out opening 12. In this case, the pair of coupling portions 13C do not extend into the first component take-out opening 12 in the lateral direction. Even in this case, since the dimension in the lateral direction of the cover member 13 inside the guide groove 15 coincides with the depth of the guide groove 15, when the electronic components M are discharged from the first component take-out opening 12, the cover member 13 inserted into the guide groove 15 makes it difficult for the electronic components M to enter the guide groove 15, thereby reducing the occurrence of the electronic components M being caught in the guide groove 15.

In the present embodiment, the maximum dimension in the length direction of the second component take-out opening 14 is equal to or greater than the dimension in the length direction of the first component take-out opening 12. This configuration makes it possible to increase the overlapping area of the first component take-out opening 12 and the second component take-out opening 14. Accordingly, it is possible to smoothly take out the electronic components M while preventing the electronic components M from being caught in the guide groove 15. Also, in the present embodiment, the dimension in the length direction of the upper cover member 13A is not particularly limited. The dimension in the length direction of the upper cover member 13A may be larger than, smaller than, or equal to the dimension in the length direction of the first component take-out opening 12.

### (Driving of Cover Member)

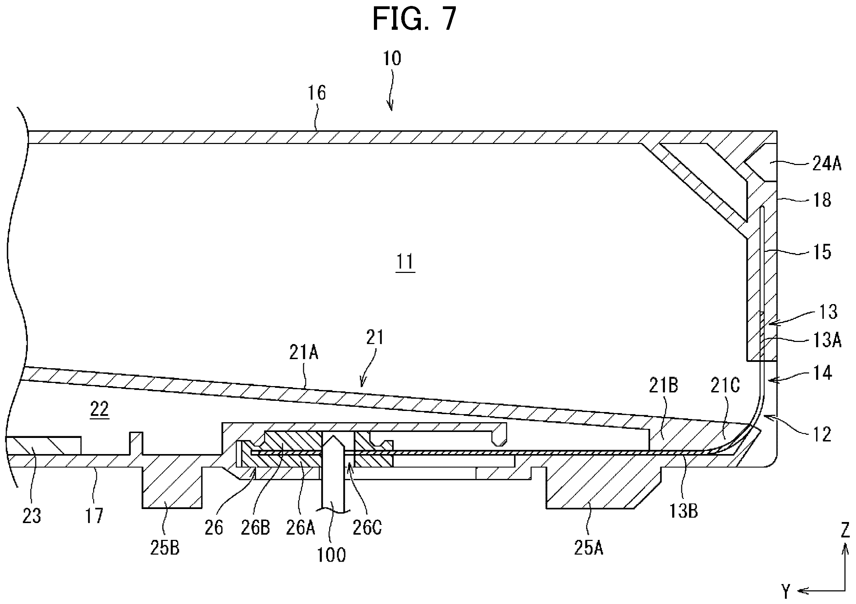

The cover member 13 slides in conjunction with the movement of the slide member 26 in the forward-backward direction.
Specifically, as shown in FIG. 7, with the cover member 13 being set, an operation pin 100 is inserted into the operation hole 26C of the slide member 26. The operation pin 100 is provided in the feeder. The operation pin 100 is inserted so as to pierce the lower cover member 13B. When the operation pin 100 is moved in the forward-backward direction, the cover member 13 slides along the guide groove 15. In FIG. 7, the operation pin 100 is located rearward, and the first component take-out opening 12 and the second component take-out opening 14 are in communication with each other.

The slide member 26 includes a first plate-shaped portion 26A provided in the lower space 22, and a second plate-shaped portion 26B provided above the cover member 13 with the cover member 13 interposed between the first plate-shaped portion 26A and the second plate-shaped portion 26B. The first plate-shaped portion 26A and the second plate-shaped portion 26B of the slide member 26 are each provided with an operation hole 26C for inserting the operation pin 100.

The slide member 26 is provided above the bottom portion 17A in the lower space 22, and is slidable integrally with the cover member 13.

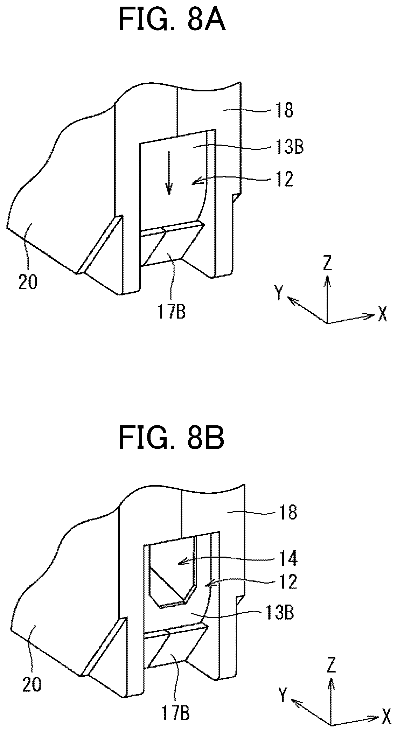

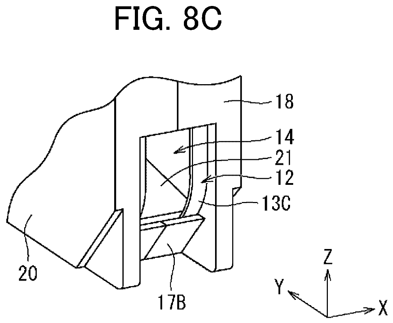

FIG. 8A is a perspective view showing a state in which the first component take-out opening 12 is closed by the cover member 13 in Embodiment 1 of the component storage container 1. FIG. 8B is a perspective view showing a state in which a portion of the second component take-out opening 14 of the cover member 13 and the first component take-out opening 12 are in communication with each other in Embodiment 1. FIG. 8C is a perspective view showing a state in which the second component take-out opening 14 of the cover member 13 and the first component take-out opening 12 are in communication with each other in Embodiment 1.

In the cover member 13 of the present embodiment, the longitudinal dimension of the lower cover member 13B is equal to or greater than the longitudinal dimension (dimension in the length direction) of the first component take-out opening 12. This configuration makes it possible, by sliding the cover member 13, to switch between a state in which the first component take-out opening 12 and the second component take-out opening 14 are not in communication with each other and a state in which the first component take-out opening 12 and the second component take-out opening 14 are in communication with each other.

The cover member 13 is first installed such that the lower cover member 13B and the first component take-out opening 12 overlap each other (FIG. 8A). Both end portions of the cover member 13 in the lateral direction are provided so as to be inserted into the guide groove 15, and are slidable along the first component take-out opening 12. The first component take-out opening 12 is entirely covered by the lower cover member 13B and is closed. Next, by sliding the lower cover member 13B downward, and then rearward, the second component take-out opening 14 and the first component take-out opening 12 are in communication with each other, and the storage space 11 changes from a closed state to an open state (FIGS. 8B and 8C). The sliding direction of the cover member 13 is not limited to this, and the upper cover member 13A may be slid forward, and then upward.

### <Embodiment 2>

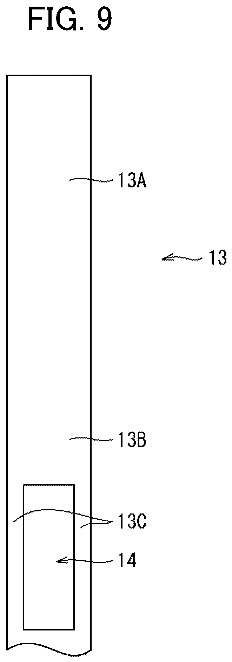

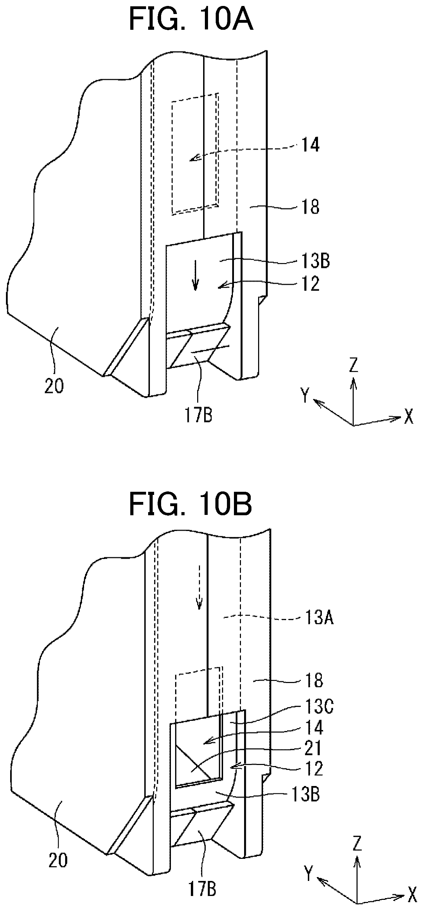

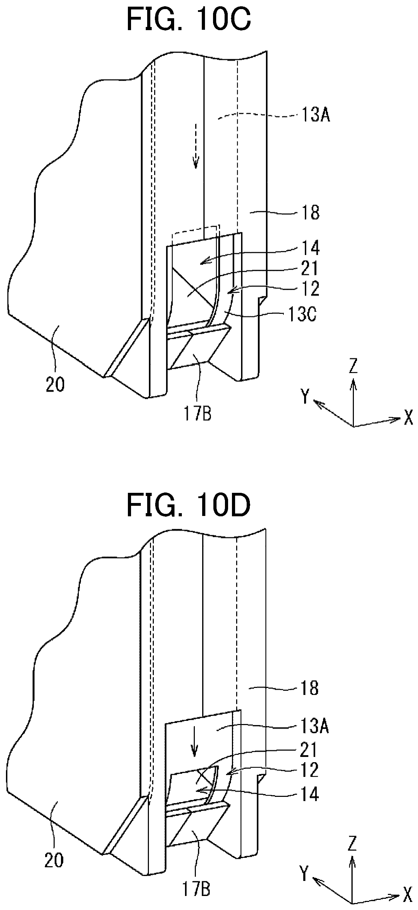

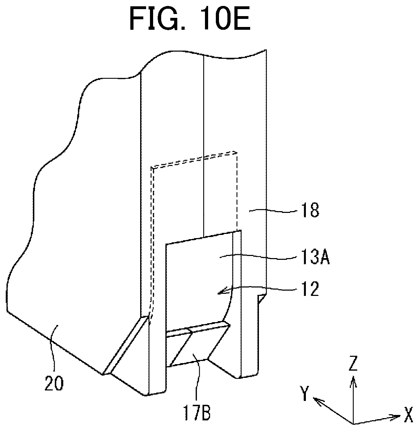

FIG. 9 is a plan view showing an example of a cover member used in Embodiment 2. FIG. 10A is a perspective view showing a state in which the first component take-out opening 12 is closed by the cover member 13 in Embodiment 2. FIG. 10B is a perspective view showing a state in which a portion of the second component take-out opening 14 of the cover member 13 and the first component take-out opening 12 are in communication with each other in Embodiment 2. FIG. 10C is a perspective view showing a state in which the second component take-out opening 14 of the cover member 13 and the first component take-out opening 12 are in communication with each other in Embodiment 2. FIG. 10D is a perspective view showing a state in which a portion of the second component take-out opening 14 of the cover member 13 and the first component take-out opening 12 are in communication with each other in Embodiment 2. FIG. 10E is a perspective view showing a state in which the first component take-out opening 12 is closed by the cover member 13 in Embodiment 2. Embodiment 2 differs from Embodiment 1 in the shape of the cover member. Specifically, the longitudinal dimension of the upper cover member 13A is different. This different configuration will be described below. The other configurations are the same as those in Embodiment 1, and the same reference numerals as in Embodiment 1 are assigned and the descriptions thereof are omitted.

In the cover member 13 of Embodiment 1, the longitudinal dimension of the lower cover member 13B is equal to or greater than the longitudinal dimension (dimension in the height direction Z) of the first component take-out opening 12; whereas, in the present embodiment, the longitudinal dimensions of both the upper cover member 13A and the lower cover member 13B are equal to or greater than the longitudinal dimension (dimension in the height direction Z) of the first component take-out opening 12.

Also in the present embodiment, the longitudinal dimension of the second component take-out opening 14 is preferably equal to or greater than the longitudinal dimension of the first component take-out opening 12; however, the present invention is not limited thereto.

The shape of the second component take-out opening 14 of the present embodiment is rectangular. However, the shape of the second component take-out opening 14 is not limited to this, and may be a rectangular shape with rounded corners as in Embodiment 1, or may be, for example, a polygonal shape, an elliptical shape, or a circular shape.

By installing the cover member 13 having the above configuration in the case body 10, by sliding the cover member 13 in only one direction of the longitudinal direction, the state changes in the following order: a state in which the inside and outside of the case body 10 are partitioned (FIG. 10A), a state in which at least a portion of the first component take-out opening 12 and at least a portion of the second component take-out opening 14 overlap and the inside and outside of the case body 10 are in communication with each other (FIGS. 10B to 10D), and a state in which the inside and outside of the case body 10 are partitioned by the cover member 13 (FIG. 10E).

According to the configuration of the cover member 13 of the present embodiment, in addition to making it unlikely for the electronic components M to be caught in the guide groove 15, by sliding the cover member 13 in one direction, it is possible to sequentially change the storage space 11 to a closed state, an open state, and a closed state. Therefore, it is not necessary to switch the sliding direction of the cover member 13 in order to open and close the storage space 11, thereby reducing complexity.

### <Embodiment 3>

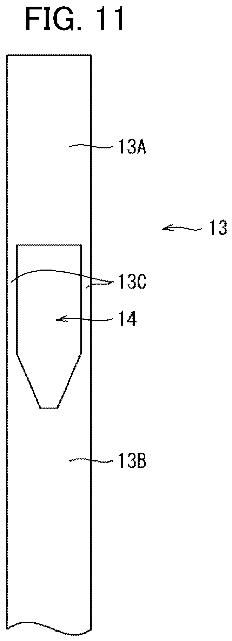

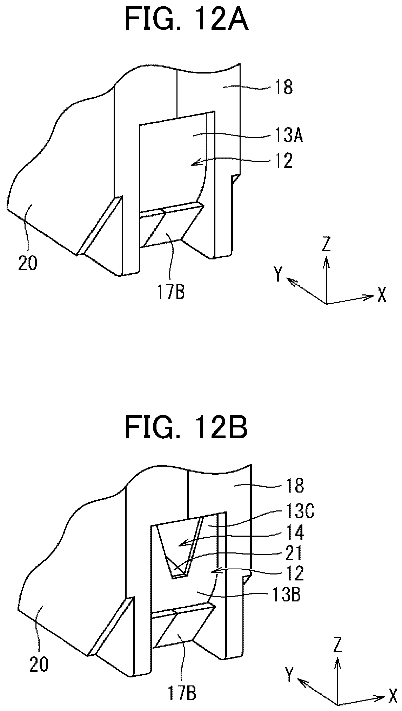

FIG. 11 shows an example of the cover member 13 used in Embodiment 3. FIG. 12A is a perspective view showing a state in which the first component take-out opening 12 is closed by the cover member 13 in Embodiment 3. FIG. 12B is a perspective view showing a state in which a portion of the second component take-out opening 14 of the cover member 13 and the first component take-out opening 12 are in communication with each other in Embodiment 3. FIG. 12C is a perspective view showing a state in which the second component take-out opening 14 of the cover member 13 and the first component take-out opening 12 are in communication with each other in Embodiment 3. Embodiment 3 differs from Embodiment 1 in the shape of the second component take-out opening 14. This different configuration will be described below. The other configurations are the same as those in Embodiment 1, and the same reference numerals as in Embodiment 1 are assigned and the descriptions thereof are omitted.

In Embodiment 1 and Embodiment 2, the shape of the second component take-out opening 14 is a rectangular shape, but the second component take-out opening 14 of the present embodiment has a shape combining a rectangular shape and a shape in which the lateral direction dimension gradually decreases. As shown in FIG. 11, the shape of the second component take-out opening 14 of the present embodiment is a shape combining a rectangular shape and a triangular shape.

The cover member 13 of the present embodiment, similarly to Embodiment 1, has a longitudinal dimension of the lower cover member 13B that is equal to or greater than the longitudinal dimension of the first component take-out opening 12. This allows the lower cover member 13B to close the first component take-out opening 12.

The cover member 13 is first installed in the case body 10 such that the cover member 13 other than the second component take-out opening 14 and the first component take-out opening 12 overlap each other (FIG. 12A). Both end portions of the cover member 13 in the lateral direction are provided so as to be inserted into the guide groove 15, and are slidable along the first component take-out opening 12. The first component take-out opening 12 is entirely covered by the lower cover member 13B and is closed. Next, the cover member 13 is slid. Thus, the second component take-out opening 14 and the first component take-out opening 12 are in communication with each other, and the storage space 11 changes from a closed state to an open state (FIGS. 12B and 12C).

In the present embodiment, the second component take-out opening 14 has a shape in which the longitudinal dimension gradually decreases. By sliding the cover member 13 having such a configuration, the overlapping area of the first component take-out opening 12 and the second component take-out opening 14 can be gradually increased or decreased. This makes it easy to adjust the amount of the electronic components M to be taken out.

The shape of the second component take-out opening 14 may be, for example, a shape combining a rectangular shape and a triangular shape, or may be a shape combining a rectangular shape and an elliptical shape.

The longitudinal dimension of the upper cover member 13A may also be equal to or greater than the longitudinal dimension of the first component take-out opening 12. Thus, similarly to Embodiment 2, sliding the cover member 13 in one direction makes it possible to sequentially change the storage space 11 to a closed state, an open state, and a closed state. Therefore, it is not necessary to switch the sliding direction of the cover member 13 in order to open and close the storage space 11, thereby reducing complexity.

The longitudinal dimension of the second component take-out opening 14 may be equal to or greater than the longitudinal dimension of the first component take-out opening 12. This configuration makes it possible to increase the overlapping area of the first component take-out opening 12 and the second component take-out opening 14, and to smoothly take out the electronic components M while adjusting the amount of the electronic components M to be taken out.

### <Embodiment 4>

Embodiment 4 is a component storage container with components in which a plurality of electronic components M are stored in a loose state in the storage space 11. The configuration of the component storage container is the same as that of Embodiment 1, 2, or 3. The present embodiment is shown in FIG. 5.

### (Relationship Between Stored Electronic Components M and Second Component take-out opening 14)

In the component storage container with components in which a plurality of electronic components M are stored in a loose state in the storage space 11, the maximum dimension in the lateral direction of the second component take-out opening 14 is preferably five times or more the maximum dimension of each of the electronic components stored in the storage space 11.

Thus, when the second component take-out opening 14 and the first component take-out opening 12 are in communication with each other, the maximum dimension in the lateral direction of the opening formed by the overlapping of the first component take-out opening 12 and the second component take-out opening 14 is sufficiently large with respect to the maximum dimension of the stored components. Therefore, clogging of the electronic components M at the opening is eliminated, and the electronic components M in the storage space 11 are smoothly taken out.

In the present embodiment, the width of the guide groove 15 is preferably larger than the thickness of the cover member 13, and the difference between the width of the guide groove 15 and the thickness of the cover member 13 is preferably smaller than the minimum dimension of each of the electronic components M accommodated in the storage space 11.

The present disclosure is not limited to the above-described embodiments, and design modifications can be made without departing from the gist of the present disclosure.

In the above-described embodiments, the shapes of the first component take-out opening 12 and the second component take-out opening 14 are substantially the same, but they may be different from each other.

In the above-described Embodiments 1 and 3, the longitudinal dimension of the lower cover member 13B is equal to or greater than the longitudinal dimension of the first component take-out opening 12, but further, the longitudinal dimension of the upper cover member 13A may also be equal to or greater than the longitudinal dimension of the first component take-out opening 12. The longitudinal dimension of the second component take-out opening 14 may be equal to or greater than the longitudinal dimension of the first component take-out opening 12. The configurations of these cover members 13 can be combined where appropriate.

In Embodiments 1 to 3, the lateral direction dimension of the portion of the cover member 13 inserted into the guide groove 15 substantially matches the depth of the guide groove 15, but the present invention is not limited to this. For example, the lateral direction dimension of the portion of the cover member 13 inserted into the guide groove 15 may be smaller than the depth of the guide groove 15. In this case, the cover member 13 slides more easily.

In Embodiments 1 to 3, the lateral direction dimension of the cover member 13 is constant, but the present invention is not limited to this. For example, the lateral direction dimension of the cover member 13 may vary along the longitudinal direction.

<1> A component storage container includes: a case body including a storage space for storing a plurality of components, and a first component take-out opening for taking components in and out of the storage space; a cover member that is slidable along the first component take-out opening to open and close the first component take-out opening;
   a second component take-out opening provided in the cover member; and
   a guide groove provided in the case body to guide the cover member. When a direction in which the cover member extends is defined as a longitudinal direction, and a direction intersecting the longitudinal direction is defined as a lateral direction, the second component take-out opening is provided at a position excluding an end portion of the cover member in the lateral direction, and a maximum dimension of the second component take-out opening in the lateral direction is equal to or less than a maximum dimension of the first component take-out opening in the lateral direction.
<2> In the component storage container as described in <1> above, in a state where at least a portion of the first component take-out opening and at least a portion of the second component take-out opening overlap each other such that an inside and an outside of the case body are in communication with each other, a portion of the cover member extends into the first component take-out opening in the lateral direction.
<3> In the component storage container as described in <1> or <2> above, a maximum dimension of the second component take-out opening in the longitudinal direction is equal to or greater than a maximum dimension of the first component take-out opening in the longitudinal direction.
<4> In the component storage container as described in any one of <1> to <3> above, by sliding the cover member in one direction in the longitudinal direction, a state changes in the following order: a state in which the inside and the outside of the case body are partitioned by the cover member, a state in which at least a portion of the first component take-out opening and at least a portion of the second component take-out opening overlap each other, such that the inside and the outside of the case body are in communication with each other, and a state in which the inside and the outside of the case body are partitioned by the cover member.
<5> In the component storage container as described in any one of <1> to <4> above, the cover member includes an upper cover member provided on one side of the second component take-out opening in the longitudinal direction, and a lower cover member provided on one other side of the second component take-out opening in the longitudinal direction, and a dimension of each of the upper cover member and the lower cover member in the longitudinal direction is equal to or greater than a dimension of the first component take-out opening in the longitudinal direction.
<6> A component storage container with components includes: the component storage container as described in any one of <1> to <5> above; and components stored in the storage space.
<7> In the component storage container with components as described in <6> above, a maximum dimension of the second component take-out opening in the lateral direction is five times or more of a maximum dimension of each of the components.
<8> In the component storage container with components as described in <6> or <7> above, a width of the guide groove is greater than a thickness of the cover member, and a difference between the width of the guide groove and the thickness of the cover member is smaller than a minimum dimension of each of the components stored in the storage space.

The present application claims priority based on Japanese Patent Application No. 2023-220805 filed in Japan on December 27, 2023, the entire contents of which are incorporated herein by reference.

### EXPLANATION OF REFERENCE NUMERALS

1 component storage container
2 first member
3 second member
10 case body
11 storage space
12 first component take-out opening
13 cover member
13A upper cover member
13B lower cover member
13C pair of coupling portions
14 second component take-out opening
15 guide groove
15A upper guide portion
15B lower guide portion
16 top plate portion
17 bottom plate portion
17A bottom portion
17B bottom plate end portion
18 front wall portion
19 rear wall portion
19A outer rear wall portion
19B inner rear wall portion
20 side wall portion
21 sloped portion
21A sloped surface
21B protruding portion
21C front end surface
22 lower space
23 RFID tag
24A upper gripping portion
24B rear gripping portion
25 claw portion
25A first claw portion
25B second claw portion
25C third claw portion
26 slide member
26A first plate-like portion
26B second plate-like portion
26C operation hole
100 operation pin

## Claims

1. A component storage container comprising:
a case body including a storage space for storing a plurality of components, and a first component take-out opening through which components are taken into and out of the storage space;
a cover member that is slidable along the first component take-out opening to open and close the first component take-out opening;
a second component take-out opening provided in the cover member; and
a guide groove provided in the case body to guide the cover member, wherein
when a direction in which the cover member extends is defined as a longitudinal direction, and a direction intersecting the longitudinal direction is defined as a lateral direction,
the second component take-out opening is provided at a position excluding an end portion of the cover member in the lateral direction, and
a maximum dimension of the second component take-out opening in the lateral direction is equal to or less than a maximum dimension of the first component take-out opening in the lateral direction.

2. The component storage container according to claim 1, wherein, in a state where at least a portion of the first component take-out opening and at least a portion of the second component take-out opening overlap each other such that an inside and an outside of the case body are in communication with each other, a portion of the cover member extends into the first component take-out opening in the lateral direction.

3. The component storage container according to claim 1 or 2, wherein a maximum dimension of the second component take-out opening in the longitudinal direction is equal to or greater than a maximum dimension of the first component take-out opening in the longitudinal direction.

4. The component storage container according to any one of claims 1 to 3, wherein, by sliding the cover member in one direction of the longitudinal direction,
a state changes in the following order:
a state in which the inside and the outside of the case body are partitioned by the cover member,
a state in which at least a portion of the first component take-out opening and at least a portion of the second component take-out opening overlap each other, such that the inside and the outside of the case body are in communication with each other, and
a state in which the inside and the outside of the case body are partitioned by the cover member.

5. The component storage container according to any one of claims 1 to 4, wherein
the cover member includes an upper cover member provided on one side of the second component take-out opening in the longitudinal direction, and a lower cover member provided on one other side of the second component take-out opening in the longitudinal direction, and
a dimension of each of the upper cover member and the lower cover member in the longitudinal direction is equal to or greater than a dimension of the first component take-out opening in the longitudinal direction.

6. A component storage container with components comprising: the component storage container according to any one of claims 1 to 5; and components stored in the storage space.

7. The component storage container with components according to claim 6, wherein a maximum dimension of the second component take-out opening in the lateral direction is five times or more of a maximum dimension of each of the components.

8. The component storage container with components according to claim 6 or 7, wherein a width of the guide groove is greater than a thickness of the cover member, and a difference between the width of the guide groove and the thickness of the cover member is smaller than a minimum dimension of each of the components stored in the storage space.
